# EUROPEAN PATENT APPLICATION

(11) **EP 4 535 236 A1**
(43) Date of publication of application: **09.04.2025**
(21) Application number: 24202176.4
(22) Date of filing: 24.09.2024
(51) Int. Cl.: G06N 3/063, H03M 7/30, H03M 13/13, H04L 1/00, G06N 3/082

(54) **ACCELERATOR DEVICE AND METHOD OF CONTROLLING ACCELERATOR DEVICE**

(30) Priority: 06.10.2023 KR 20230133101; 11.09.2024 US 202418830998
(71) Applicant: Samsung Electronics Co., Ltd., Suwon-si, Gyeonggi-do 16677 (KR); Naver Corporation, Seongnam-si, Gyeonggi-do 13561 (KR)
(72) Inventor: AHN, Byungmin, 16677 Suwon-si (KR); SON, Hong Rak, 16677 Suwon-si (KR); SHIN, Dong-Min, 16677 Suwon-si (KR); YANG, Dae-Yeol, 16677 Suwon-si (KR); YOON, JongYoon, 16677 Suwon-si (KR); JANG, Jae Hun, 16677 Suwon-si (KR); KWON, Se Jung, 13561 Seongnam-si (KR); KIM, Byeongwook, 13561 Seongnam-si (KR); PARK, Baeseong, 13561 Seongnam-si (KR); LEE, Dongsoo, 13561 Seongnam-si (KR)
(74) Representative: Marks & Clerk LLP

(57) **Abstract**

Disclosed is an accelerator device which includes an interface circuit that communicates with an external device, a memory that stores first data received through the interface circuit, a polar encoder that performs polar encoding with respect to the first data provided from the memory and to output a result of the polar encoding as second data, and an accelerator core that loads the second data. The first data are compressed weight data, the second data are decompressed weight data, the accelerator core is configured to perform machine learning-based inference based on the second data, and the first data are variable in length.

## Description

### BACKGROUND

Embodiments of the present disclosure described herein relate to electronic devices, and more particularly, relate to accelerator devices and methods of controlling accelerator devices.

A computing device is a type of electronic device and may execute a variety of applications based on an operating system. The computing device may include a central processing unit, an application processor, etc. as a main processor for executing the operating system and applications.

As kinds of tasks that are performed in the computing device become more diverse, accelerator devices configured to support the main processor may be added to the computing device. For example, the accelerator devices may include an image processor, a graphics processor, etc. The accelerator devices may be implemented in a separate semiconductor package to be independent of the main processor, or both the accelerator devices and the main processor may be implemented in the same semiconductor package as distinct cores.

As a task that is performed in a computing device, machine learning-based inference may be added. The machine learning-based inference requires a plurality of parallel operations and may be performed by using a graphics processor that supports parallel operations. However, because the graphics processor is not a processor designed for machine learning, the graphics processor may have a limitation in supporting machine learning.

### SUMMARY

Embodiments of the present disclosure provide accelerator devices supporting machine learning-based inference while improving an operating speed and reducing power consumption and methods of controlling accelerator devices.

According to some example embodiments, an accelerator device includes an interface circuit that communicates with an external device, a memory that stores first data received through the interface circuit, a polar encoder that performs polar encoding with respect to the first data provided from the memory and to output a result of the polar encoding as second data, and an accelerator core that loads the second data. The first data are compressed weight data, the second data are decompressed weight data, the accelerator core is configured to perform machine learning-based inference based on the second data, and the first data are variable in length.

According to some example embodiments, an accelerator device includes an interface circuit that communicates with an external device, a memory that stores first data received through the interface circuit, a polar encoder that performs polar encoding with respect to the first data provided from the memory and outputs a result of the polar encoding as second data, and an accelerator core that loads the second data. The first data are compressed weight data, the second data are decompressed weight data, the accelerator core is configured to perform machine learning-based inference based on the second data, and the second data are variable in length.

According to some example embodiments, a method of controlling an accelerator device which includes a polar encoder and an accelerator core includes inputting first data to the polar encoder, performing, at the polar encoder, polar encoding with respect to the first data to generate second data, loading the second data into the accelerator core, and performing, at the accelerator core, machine learning-based inference based on the second data. The first data are compressed weight data, the second data are decompressed weight data, and one of the first data and the second data is variable in length.

At least some of the above and other features of the invention are set out in the claims.

### BRIEF DESCRIPTION OF THE FIGURES

The above and other objects and features of the present disclosure will become apparent by describing in detail example embodiments thereof with reference to the accompanying drawings.
FIG. 1 illustrates an accelerator device according to some example embodiments of the present disclosure.
FIG. 2 illustrates an operating method of a variable length polar encoder according to some example embodiments of the present disclosure.
FIG. 3 illustrates a first example of an operating method of a variable length polar encoder according to some example embodiments of the present disclosure.
FIG. 4 illustrates a variable length polar encoder according to a first embodiment of the present disclosure.
FIG. 5 illustrates an operating method of a variable length polar encoder according to some example embodiments of the present disclosure.
FIGS. 6A to 6D illustrate an example of the process in which data chunks are processed in a buffer, a parser, and an input generator.
FIGS. 7A to 7D illustrate another example of the process in which data chunks are processed in a buffer, a parser, and an input generator.
FIG. 8 illustrates weight data according to some example embodiments of the present disclosure.
FIG. 9 is a block diagram illustrating an electronic device according to some example embodiments of the present disclosure.
FIG. 10 is a diagram illustrating a first example of an operating method of an electronic device according to some example embodiments of the present disclosure.
FIGS. 11A and 11B illustrate an example of the process in which an electronic device performs compression and decompression while changing the number of frozen bits.
FIG. 12 illustrates a second example of an operating method of a variable length polar encoder according to some example embodiments of the present disclosure.
FIG. 13 illustrates a variable length polar encoder according to a second embodiment of the present disclosure.
FIG. 14 is a diagram illustrating a second example of an operating method of an electronic device according to some example embodiments of the present disclosure.
FIGS. 15A and 15B illustrate an example of the process in which an electronic device performs compression and decompression while changing the number of frozen bits.
FIG. 16 illustrates another example of an operating method of an electronic device according to some example embodiments of the present disclosure.

### DETAILED DESCRIPTION

Below, example embodiments of the present disclosure will be described in detail and clearly to such an extent that an ordinary one in the art easily carries out the present disclosure.

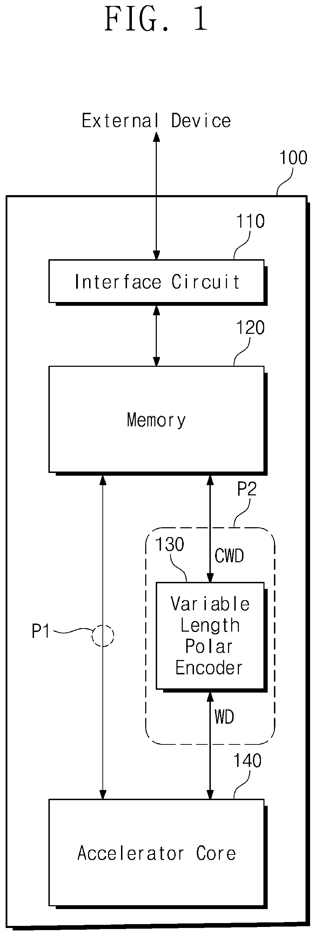

FIG. 1 illustrates an accelerator device 100 according to some example embodiments of the present disclosure. Referring to FIG. 1, the accelerator device 100 may include an interface circuit 110, a memory 120, a variable length polar encoder 130, and an accelerator core 140.

The interface circuit 110 may communicate with an external device. For example, the interface circuit 110 may communicate with an external main processor such as a central processing unit or an external memory such as a main memory of a central processing unit. The interface circuit 110 may provide the memory 120 with data transferred from the external device. The interface circuit 110 may provide data stored into the memory 120 to the external device.

For example, the interface circuit 110 may receive compressed weight data for the machine learning-based inference or input data for the machine learning-based inference from the external device and may store the received data into the memory 120. The interface circuit 110 may provide the external device with a result of the machine learning-based inference stored into the memory 120.

The memory 120 may store data transferred from the interface circuit 110. The memory 120 may provide the stored data to the accelerator core 140 through a first path P1 or may provide the stored data to the variable length polar encoder 130 through a second path P2. The memory 120 may store data transferred from the accelerator core 140. The memory 120 may provide the stored data to the interface circuit 110.

For example, the memory 120 may provide the input data for the machine learning-based inference to the accelerator core 140 through the first path P1. The memory 120 may provide compressed weight data CWD for the machine learning-based inference to the variable length polar encoder 130 through the second path P2. The memory 120 may receive and store the machine learning-based inference result from the accelerator core 140 through the first path P1.

In some example embodiments, the memory 120 may be implemented together with a memory controller (not illustrated). The memory controller may provide a channel between the memory 120 and the components (for example, the interface circuit 110, the variable length polar encoder 130, and the accelerator core 140). In some example embodiments, the memory 120 may include a dynamic random access memory (DRAM), a static RAM (SRAM), a phase change RAM (PRAM), a ferroelectric RAM (FRAM), a magnetic RAM (MRAM), a resistive RAM (RRAM), a flash memory, etc.

The variable length polar encoder 130 may receive the compressed weight data CWD from the memory 120. The variable length polar encoder 130 may generate weight data WD by decompressing the compressed weight data CWD. The variable length polar encoder 130 may provide the weight data WD to the accelerator core 140.

In some example embodiments, one of the compressed weight data CWD and the weight data WD may have a variable length. As one of the compressed weight data CWD and the weight data WD has a variable length, in this embodiment there may be guaranteed that the weight data WD is free from a defect (or free from an error). For example, the variable length may indicate that the size of data (e.g., the number of bits) is variable and may indicate that the size (e.g., the number of bits) of valid information included in data is variable.

The accelerator core 140 may receive the weight data WD from the variable length polar encoder 130. The accelerator core 140 may load (or update) a machine learning-based inference model (or module) by loading the weight data WD. The accelerator core 140 may receive machine learning-based input data from the memory 120. The accelerator core 140 may perform the machine learning-based inference based on the input data and the weight data WD. The accelerator core 140 may store a machine learning-based inference result into the memory 120.

The variable length polar encoder 130 may generate the weight data WD by decompressing the compressed weight data CWD with reduced complexity. Accordingly, a power and a time necessary to decompress the compressed weight data CWD may decrease. Also, a power and a time necessary to use the interface circuit 110 and the memory 120 may decrease by receiving the compressed weight data CWD through the interface circuit 110 and storing the compressed weight data CWD in the memory 120 while guaranteeing that the weight data WD is free from a defect.

For example, according to some example embodiments, there may be an increase in speed, accuracy, and/or power efficiency of communication and operation of the device based on the above methods. Therefore, the improved devices and methods overcome the deficiencies of the conventional devices and methods of use of weight data by neural nets, artificial intelligence, etc., while reducing resource consumption and complexity, increasing data accuracy, increasing speed of operations while also increasing data clarity.

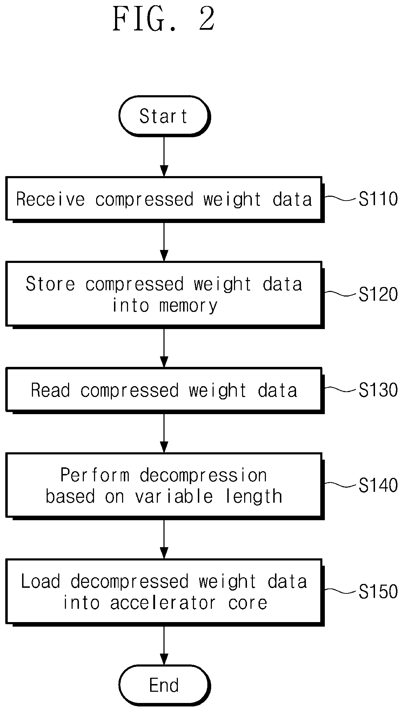

FIG. 2 illustrates an operating method of the accelerator device 100 according to some example embodiments of the present disclosure. Referring to FIGS. 1 and 2, in operation S 110, the accelerator device 100 may receive the compressed weight data CWD. For example, the accelerator device 100 may sequentially receive first data chunks corresponding to a bandwidth (e.g., a communication bandwidth) of the interface circuit 110 in synchronization with a communication frequency of the external device. The compressed weight data CWD may be included in one of the first data chunks or may be distributed and included in two or more of the first data chunks.

In operation S120, the accelerator device 100 may store the compressed weight data CWD received through the interface circuit 110 into the memory 120. For example, the accelerator device 100 may store the first data chunks including the compressed weight data CWD into the memory 120.

In operation S130, the accelerator device 100 may read the compressed weight data CWD from the memory 120. For example, the accelerator device 100 may sequentially receive second data chunks corresponding to a bandwidth (e.g., a communication bandwidth) of the memory 120 in synchronization with a communication frequency of the memory 120. The compressed weight data CWD may be included in one of the second data chunks or may be distributed and included in two or more of the second data chunks.

In operation S140, the accelerator device 100 may perform decompression based on a variable length. For example, the variable length polar encoder 130 of the accelerator device 100 may perform decompression by detecting the variable length of the compressed weight data CWD or the weight data WD included in the second data chunk(s) and performing polar encoding based on the detected variable length.

In operation S150, the accelerator device 100 may load the decompressed weight data WD into the accelerator core 140. Afterwards, based on a machine learning-based inference model (or module) corresponding to the loaded weight data WD or the weight data WD, the accelerator core 140 may perform machine learning-based inference with respect to the input data received from the external device through the interface circuit 110, the memory 120, and the first path P1.

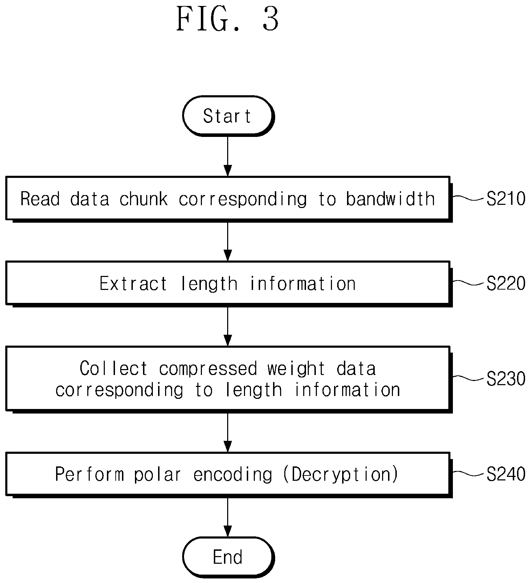

FIG. 3 illustrates a first example of an operating method of the variable length polar encoder 130 according to some example embodiments of the present disclosure. Referring to FIGS. 1 and 3, in operation S210, the variable length polar encoder 130 may read a data chunk corresponding to a bandwidth. For example, the variable length polar encoder 130 may read a data chunk (e.g., the second data chunk described with reference to FIG. 2) corresponding to the communication bandwidth of the memory 120.

In operation S220, the variable length polar encoder 130 may extract length information. For example, the variable length polar encoder 130 may extract the length information at a given location of the read data chunk. Alternatively, the variable length polar encoder 130 may extract the length information at a given location of data buffered in the variable length polar encoder 130. The length information may indicate a length of compressed weight data. For example, the given location may mean a given number of leading bits of the data chunk or the buffered data. As an example, the length information may be a value within the read data chunk indicating the length of the compressed weight data.

When the length information does not exist at the given location of the read data chunk or the buffered data, the variable length polar encoder 130 may omit the extraction of the length information. For example, when length information extracted from a previous data chunk is still valid (e.g., when the whole compressed weight data corresponding to the length information are not collected), the length information may not exist at the given location of the current data chunk or the buffered data.

In operation S230, the variable length polar encoder 130 may collect the compressed weight data CWD corresponding to the length information. For example, the compressed weight data CWD corresponding to the length information may be collected from one data chunk or may be collected from two or more data chunks.

When the compressed weight data CWD corresponding to the length information are collected, in operation S240, the variable length polar encoder 130 may perform decompression by performing polar encoding. When the decompression is performed, the variable length polar encoder 130 may discard the length information and may update the length information by extracting next length information. Also, when the decompression is performed, the variable length polar encoder 130 may output the weight data WD.

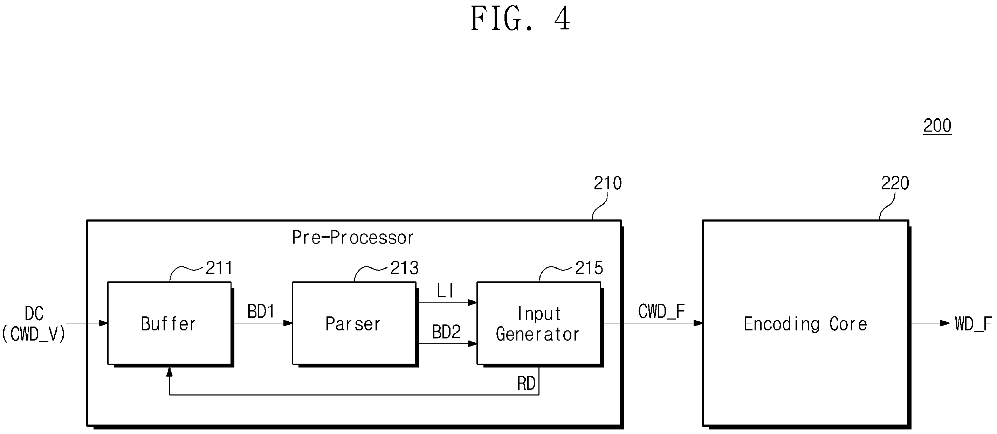

FIG. 4 illustrates the variable length polar encoder 200 according to a first embodiment of the present disclosure. In some example embodiments, a variable length polar encoder 200 may correspond to the variable length polar encoder 130 of FIG. 1.

Referring to FIGS. 1 and 4, the variable length polar encoder 200 may include a pre-processor 210 and an encoding core 220. The pre-processor 210 may sequentially receive data chunks DC from the memory 120. At least one data chunk DC may include a length-variable compressed weight data CWD_V. The pre-processor 210 may convert the length-variable compressed weight data CWD_V included in the data chunk DC into a length-fixed compressed weight data CWD_F. For example, the length of the length-fixed compressed weight data CWD_F may correspond to an encoding unit of the encoding core 220.

The pre-processor 210 may include a buffer 211, a parser 213, and an input generator 215. The buffer 211 may store the data chunk DC. The buffer 211 may output the stored data as first buffering data BD1.

The parser 213 may receive the first buffering data BD1 from the buffer 211. The parser 213 may extract length information LI from the first buffering data BD1. For example, the parser 213 may extract the length information LI from a given location of the first buffering data BD1, for example, from a given number of leading bits of the first buffering data BD1. The parser 213 may generate second buffering data BD2 excluding the length information LI from the first buffering data BD1. The parser 213 may output the length information LI and the second buffering data BD2 to the input generator 215.

The input generator 215 may extract the length-variable compressed weight data CWD_V from the second buffering data BD2 based on the length information LI. The input generator 215 may generate the length-fixed compressed weight data CWD_F from the length-variable compressed weight data CWD_V. For example, the input generator 215 may generate the length-fixed compressed weight data CWD_F by padding bits with a given value or an arbitrary value behind the length-variable compressed weight data CWD_V.

The input generator 215 may again store remaining data RD of the second buffering data BD2, which do not correspond to the length-variable compressed weight data CWD_V, into the buffer 211. For example, the remaining data RD may correspond to the length-variable compressed weight data CWD_V targeted for next polar encoding.

The encoding core 220 may receive the length-fixed compressed weight data CWD_F from the pre-processor 210. The encoding core 220 may perform decompression by performing polar encoding with respect to the length-fixed compressed weight data CWD_F. The encoding core 220 may output length-fixed weight data WD_F as a decompression result. For example, the length-fixed weight data WD_F may correspond to the weight data WD transferred from the variable length polar encoder 130 to the accelerator core 140.

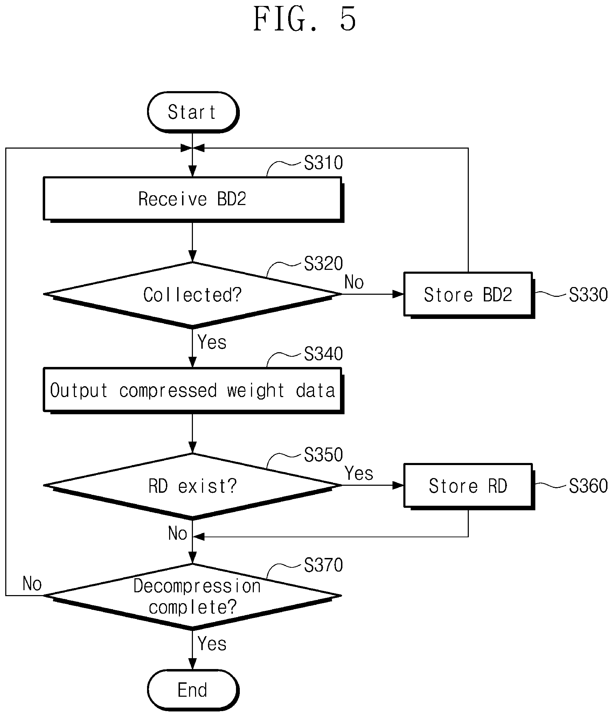

FIG. 5 illustrates an operating method of the variable length polar encoder 200 according to some example embodiments of the present disclosure. An example of an operating method of the input generator 215 of the variable length polar encoder 200 is illustrated in FIG. 5.

Referring to FIGS. 4 and 5, in operation S310, the input generator 215 may receive the second buffering data BD2.

In operation S320, the input generator 215 may determine whether data corresponding to the length information LI are collected. When the data corresponding to the length information LI are not collected, in operation S330, the input generator 215 may further include the second buffering data BD2 in operation S310, with the second buffering data BD2 stored therein. When the data corresponding to the length information LI are collected, that is, when data whose amount is greater than or equal to the length information LI, operation S340 is performed.

In operation S340, the input generator 215 may output compressed weight data. For example, the input generator 215 may identify the data corresponding to the length information LI as the length-variable compressed weight data CWD_V. The input generator 215 may generate the length-fixed compressed weight data CWD_F by padding given bits or arbitrary bits to the length-variable compressed weight data CWD_V. The input generator 215 may output the length-fixed compressed weight data CWD_F

In operation S350, the input generator 215 may determine whether the remaining data RD exist. When the remaining data RD exist, in operation S360, the input generator 215 may store the remaining data RD into the buffer 211. Afterwards, operation S370 is performed. When the remaining data RD do not exist, operation S370 is performed.

In operation S370, whether decompression is completed may be determined. When the decompression is not completed, in operation S310, the input generator 215 may receive the second buffering data BD2. When the decompression is completed, the input generator 215 may end the process.

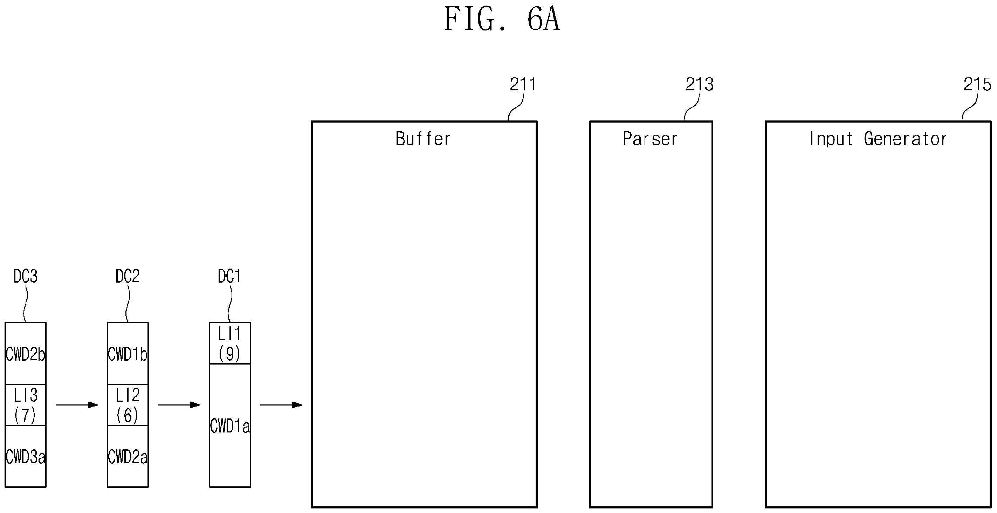

FIGS. 6A to 6D illustrate an example of the process in which data chunks are processed in the buffer 211, the parser 213, and the input generator 215. In some example embodiments, an example in which the size of data chunks is smaller than the size of the length-variable compressed weight data CWD_V is illustrated in FIGS. 6A to 6D.

Referring to FIG. 6A, a first data chunk DC1, a second data chunk DC2, and a third data chunk DC3 may be sequentially input to the buffer 211. The first data chunk DC1 may include first length information LI1 and 1a-th compressed weight data CWD1a. The second data chunk DC2 may include 1b-th compressed weight data CWD1b, second length information LI2, and 2a-th compressed weight data CWD2a. The third data chunk DC3 may include 2b-th compressed weight data CWD2b, third length information LI3, and 3a-th compressed weight data CWD3a.

The 1a-th compressed weight data CWD1a and the 1b-th compressed weight data CWD1b may correspond to one length-variable compressed weight data CWD_V. The first length information LI1 may indicate a total length of the 1a-th compressed weight data CWD1a and the 1b-th compressed weight data CWD1b and may indicate, for example, "9".

The 2a-th compressed weight data CWD2a and the 2b-th compressed weight data CWD2b may correspond to one length-variable compressed weight data CWD_V. The second length information LI2 may indicate a total length of the 2a-th compressed weight data CWD2a and the 2b-th compressed weight data CWD2b and may indicate, for example, "6".

The 3a-th compressed weight data CWD3a may correspond to one length-variable compressed weight data CWD_V together with any other compressed weight data (e.g., 3b-th compressed weight data). The third length information LI3 may indicate a total length of the 3a-th compressed weight data CWD3a and the other compressed weight data and may indicate, for example, "7".

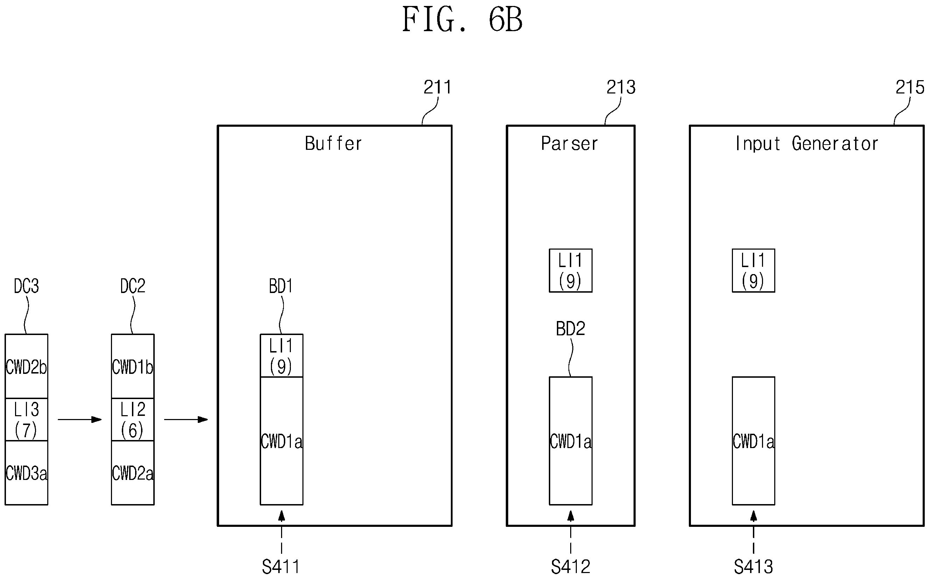

Referring to FIG. 6B, in operation S411, the buffer 211 may receive the first data chunk DC1 and may store the first data chunk DC1 as the first buffering data BD1. The buffer 211 may output the first buffering data BD1 to the parser 213.

In operation S412, the parser 213 may extract the first length information LI1 from given locations of the first buffering data BD1, for example, from a given number of leading bits of the first buffering data BD1. The parser 213 may remove the first length information LI1 from the first buffering data BD1 to generate the second buffering data BD2. The parser 213 may output the first length information LI1 and the second buffering data BD2 to the input generator 215.

In operation S413, the input generator 215 may receive the second buffering data BD2 including the first length information LI1 and the 1a-th compressed weight data CWD1a. Because the whole data corresponding to the first length information LI1 are not collected, the input generator 215 may not output the length-fixed compressed weight data CWD_F.

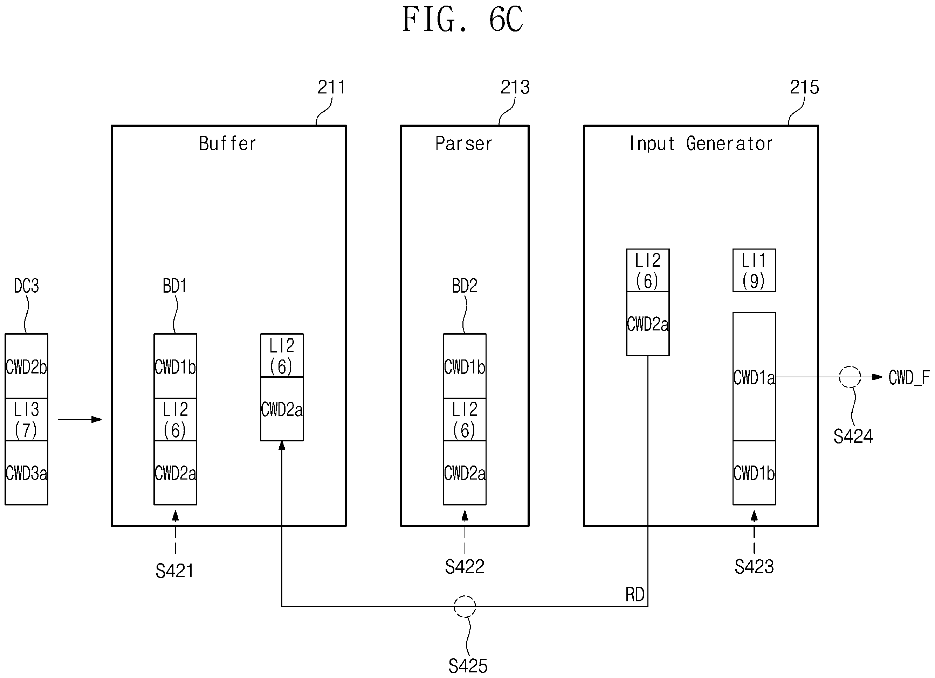

Referring to FIG. 6C, in operation S421, the buffer 211 may receive the second data chunk DC2 and may store the second data chunk DC2 as the first buffering data BD1. The buffer 211 may output the first buffering data BD1 to the parser 213.

In operation S422, the parser 213 may determine whether length information exists at given locations of the first buffering data BD1, for example, at a given number of leading bits of the first buffering data BD1. Because the length information does not exist at the given locations of the first buffering data BD1, the parser 213 may output the received data to the input generator 215 as the second buffering data BD2. The parser 213 may omit the output of length information.

In operation S423, the input generator 215 may receive the second buffering data BD2. The input generator 215 may collect data corresponding to the first length information LI1 based on the data previously stored in the input generator 215 and the second buffering data BD2.

In operation S424, the input generator 215 may output the 1a-th compressed weight data CWD1a and the 1b-th compressed weight data CWD1b, which correspond to the first length information LI1, as the length-fixed compressed weight data CWD_F. For example, when the length of "9" indicated by the first length information LI1 corresponds to a fixed length, the input generator 215 may output the length-variable compressed weight data CWD_V, which include the 1a-th compressed weight data CWD1a and the 1b-th compressed weight data CWD1b, as the length-fixed compressed weight data CWD_F without padding.

In operation S425, the input generator 215 may again store the second length information LI2 and the 2a-th compressed weight data CWD2a into the buffer 211 as the remaining data RD.

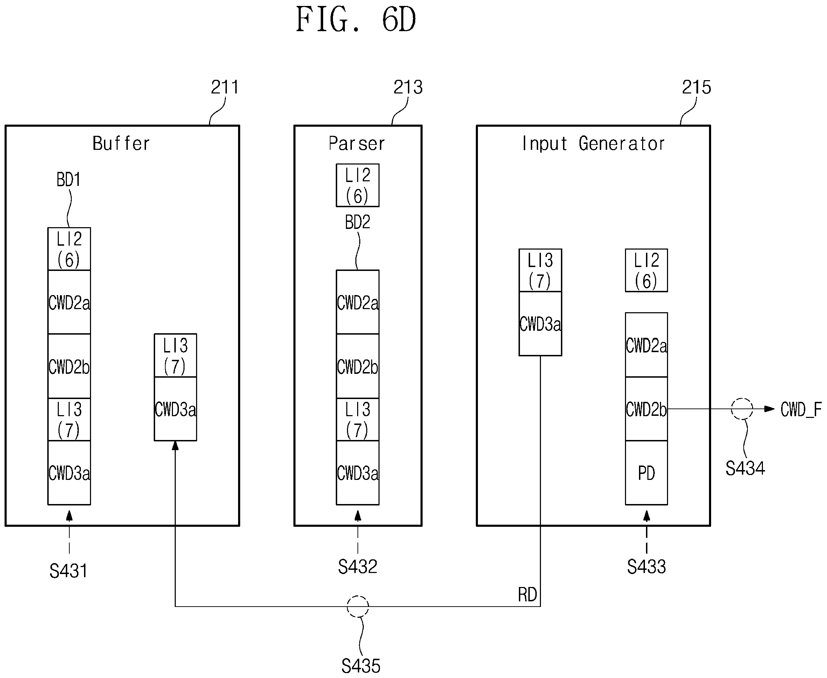

Referring to FIG. 6D, in operation S431, the buffer 211 may receive and store the third data chunk DC3. The buffer 211 may output the second length information LI2 and the 2a-th compressed weight data CWD2a, which constitute the remaining data RD of the second data chunk DC2, and the 2b-th compressed weight data CWD2b, the third length information LI3, and the 3a-th compressed weight data CWD3a of the third data chunk DC3 to the parser 213 as the first buffering data BD1.

In operation S432, the parser 213 may extract the second length information LI2 from given locations of the first buffering data BD1, for example, from a given number of leading bits of the first buffering data BD1. The parser 213 may remove the second length information LI2 from the first buffering data BD1 to generate the second buffering data BD2. The parser 213 may output the second length information LI2 and the second buffering data BD2 to the input generator 215.

In operation S433, the input generator 215 may receive the second buffering data BD2. The input generator 215 may collect data corresponding to the second length information LI2 based on the second buffering data BD2.

In operation S434, the input generator 215 may output the length-fixed compressed weight data CWD_F obtained by adding padding data PD to the 2a-th compressed weight data CWD2a and the 2b-th compressed weight data CWD2b, which correspond to the second length information LI2. For example, the padding data PD may have a given value or an arbitrary value. The length of the padding data PD may correspond to a difference between the length of the encoding unit of the encoding core 220 (refer to FIG. 4) and the length of the length-variable compressed weight data CWD_V.

In operation S435, the input generator 215 may again store the third length information LI3 and the 3a-th compressed weight data CWD3a into the buffer 211 as the remaining data RD.

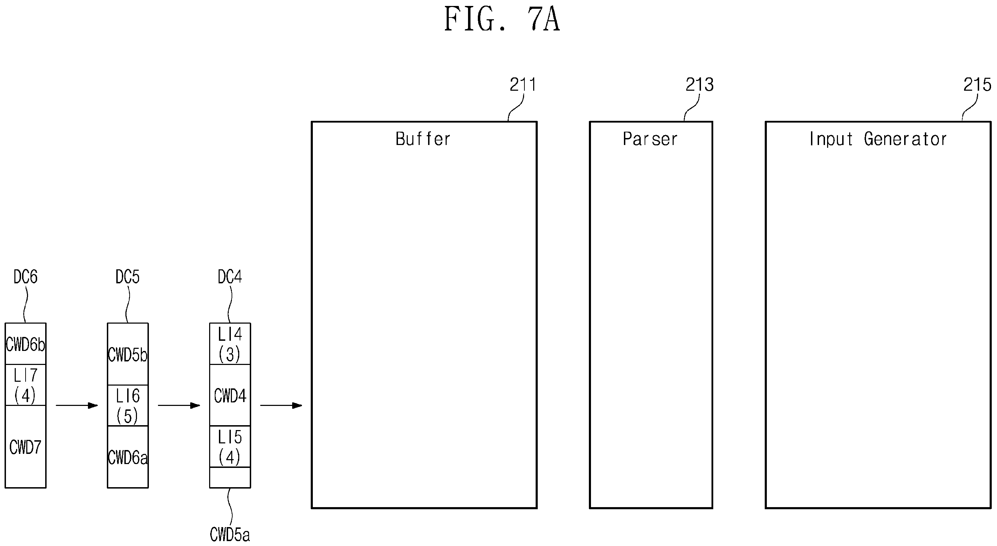

FIGS. 7A to 7D illustrate another example of the process in which data chunks are processed in the buffer 211, the parser 213, and the input generator 215. An example in which the size of data chunks is greater than the size of the length-variable compressed weight data CWD_V is illustrated in FIGS. 7A to 7D.

Referring to FIG. 7A, a fourth data chunk DC4, a fifth data chunk DC5, and a sixth data chunk DC6 may be sequentially input to the buffer 211. The fourth data chunk DC4 may include fourth length information LI4, fourth compressed weight data CWD4, fifth length information LI5, and 5a-th compressed weight data CWD5a. The fifth data chunk DC5 may include 5b-th compressed weight data CWD5b, sixth length information LI6, and 6a-th compressed weight data CWD6a. The sixth data chunk DC6 may include 6b-th compressed weight data CWD6b, seventh length information LI7, and seventh compressed weight data CWD7.

The fourth compressed weight data CWD4 may correspond to one length-variable compressed weight data CWD_V. The fourth length information LI4 may indicate a total length of the fourth compressed weight data CWD4 and may indicate, for example, "3".

The 5a-th compressed weight data CWD5a and the 5b-th compressed weight data CWD5b may correspond to one length-variable compressed weight data CWD_V. The fifth length information LI5 may indicate a total length of the 5a-th compressed weight data CWD5a and the 5b-th compressed weight data CWD5b and may indicate, for example, "4".

The 6a-th compressed weight data CWD6a and the 6b-th compressed weight data CWD6b may correspond to one length-variable compressed weight data CWD_V. The sixth length information LI6 may indicate a total length of the 6a-th compressed weight data CWD6a and the 6b-th compressed weight data CWD6b and may indicate, for example, "5".

The seventh compressed weight data CWD7 may correspond to one length-variable compressed weight data CWD_V. The seventh length information LI7 may indicate a total length of the seventh compressed weight data CWD7 and may indicate, for example, "4".

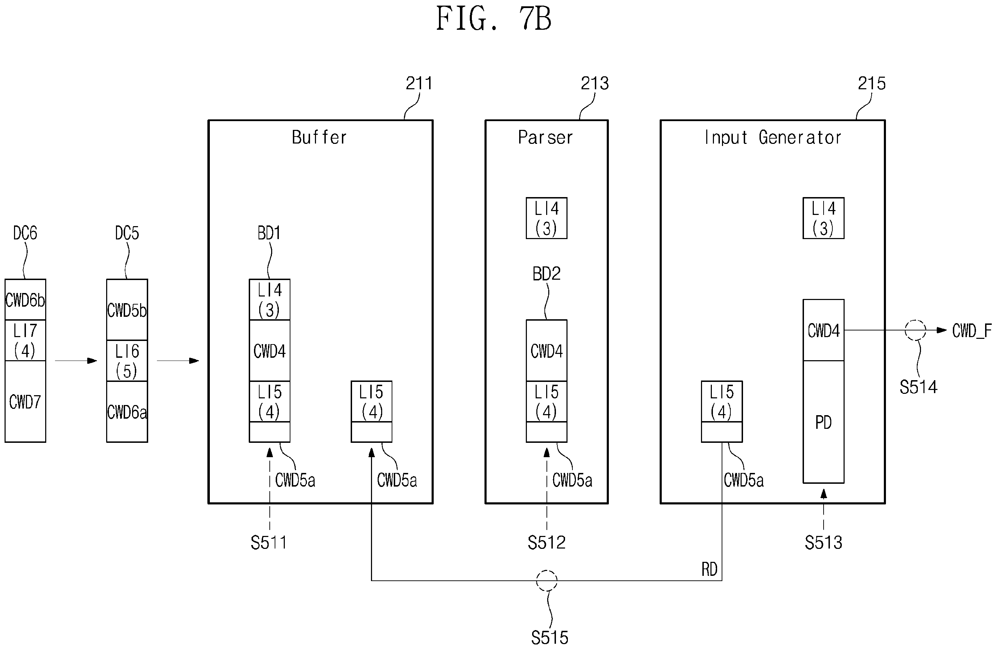

Referring to FIG. 7B, in operation S511, the buffer 211 may receive the fourth data chunk DC4 and may store the fourth data chunk DC4 as the first buffering data BD1. The buffer 211 may output the first buffering data BD1 to the parser 213.

In operation S512, the parser 213 may extract the fourth length information LI4 from given locations of the first buffering data BD1, for example, from a given number of leading bits of the first buffering data BD1. The parser 213 may remove the fourth length information LI4 from the first buffering data BD1 to generate the second buffering data BD2. The parser 213 may output the fourth length information LI4 and the second buffering data BD2 to the input generator 215.

In operation S513, the input generator 215 may receive the second buffering data BD2 including the fourth length information LI4 and the fourth compressed weight data CWD4. Because the whole data corresponding to the fourth length information LI4 are collected, in operation S514, the input generator 215 may output the length-fixed compressed weight data CWD_F obtained by adding the padding data PD to the fourth compressed weight data CWD4.

In operation S515, the input generator 215 may again store the fifth length information LI5 and the 5a-th compressed weight data CWD5a into the buffer 211 as the remaining data RD.

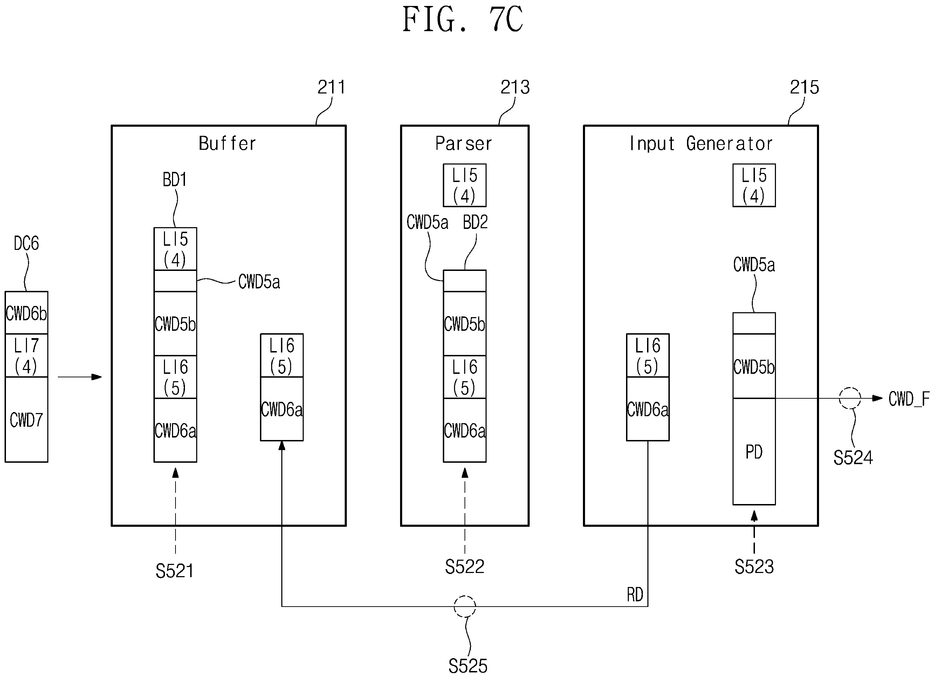

Referring to FIG. 7C, in operation S521, the buffer 211 may receive and store the fifth data chunk DC5. The buffer 211 may output the fifth length information LI5 and the 5a-th compressed weight data CWD5a, which constitute the remaining data RD of the fourth data chunk DC4, and the 5b-th compressed weight data CWD5b, the sixth length information LI6, and the 6a-th compressed weight data CWD6a of the fifth data chunk DC5 to the parser 213 as the first buffering data BD1.

In operation S522, the parser 213 may extract the fifth length information LI5 from given locations of the first buffering data BD1, for example, from a given number of leading bits of the first buffering data BD1. The parser 213 may remove the fifth length information LI5 from the first buffering data BD1 to generate the second buffering data BD2. The parser 213 may output the fifth length information LI5 and the second buffering data BD2 to the input generator 215. In some example embodiments, when first buffering data BD1 includes multiple length information (such as first buffering data BD1 including length information LI5 and length information LI6), only the initial (or first) encountered length information may be extracted (such as only length information LI5 being extracted and not length information LI6). In some example embodiments, a particular length information may be selected or desired based on user preference, operating parameters or other information. In operation S523, the input generator 215 may collect data corresponding to the fifth length information LI5 based on the second buffering data BD2.

In operation S524, the input generator 215 may output the length-fixed compressed weight data CWD_F obtained by adding the padding data PD to the 5a-th compressed weight data CWD5a and the 5b-th compressed weight data CWD5b, which correspond to the fifth length information LI5. For example, the padding data PD may have a given value or an arbitrary value. The length of the padding data PD may correspond to a difference between the length of the encoding unit of the encoding core 220 (refer to FIG. 4) and the length of the length-variable compressed weight data CWD_V.

In operation S525, the input generator 215 may again store the sixth length information LI6 and the 6a-th compressed weight data CWD6a into the buffer 211 as the remaining data RD.

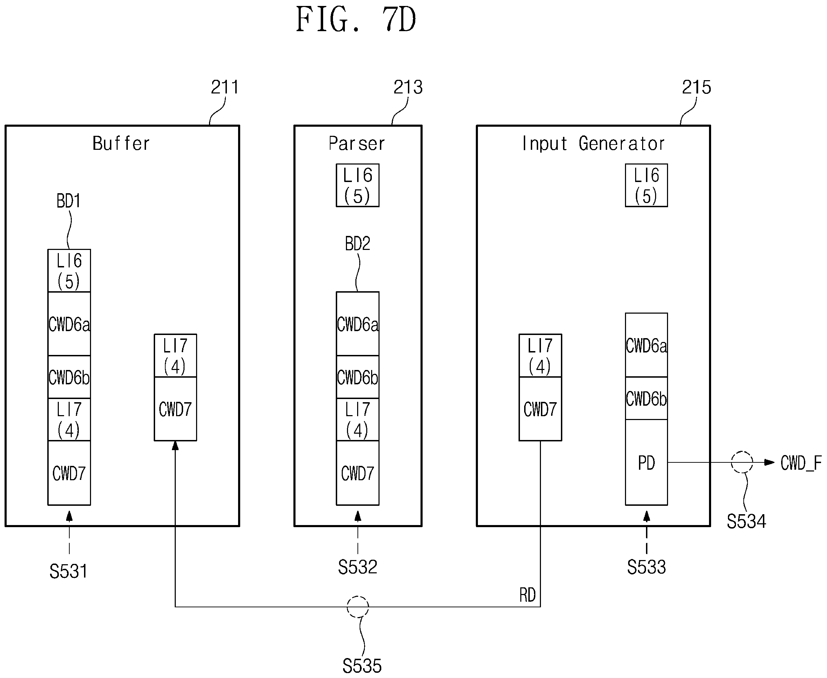

Referring to FIG. 7D, in operation S531, the buffer 211 may receive and store the sixth data chunk DC6. The buffer 211 may output the sixth length information LI6 and the 6a-th compressed weight data CWD6a, which constitute the remaining data RD of the fifth data chunk DC5, the 6b-th compressed weight data CWD6b, the seventh length information LI7, and the seventh compressed weight data CWD7 of the sixth data chunk DC6 to the parser 213 as the first buffering data BD1.

In operation S532, the parser 213 may extract the sixth length information LI6 from given locations of the first buffering data BD1, for example, from a given number of leading bits of the first buffering data BD1. The parser 213 may remove the sixth length information LI6 from the first buffering data BD1 to generate the second buffering data BD2. The parser 213 may output the sixth length information LI6 and the second buffering data BD2 to the input generator 215.

In operation S533, the input generator 215 may collect data corresponding to the sixth length information LI6 based on the second buffering data BD2.

In operation S534, the input generator 215 may output the length-fixed compressed weight data CWD_F obtained by adding the padding data PD to the 6a-th compressed weight data CWD6a and the 6b-th compressed weight data CWD6b, which correspond to the sixth length information LI6. In operation S535, the input generator 215 may again store the seventh length information LI7 and the seventh compressed weight data CWD7 into the buffer 211 as the remaining data RD.

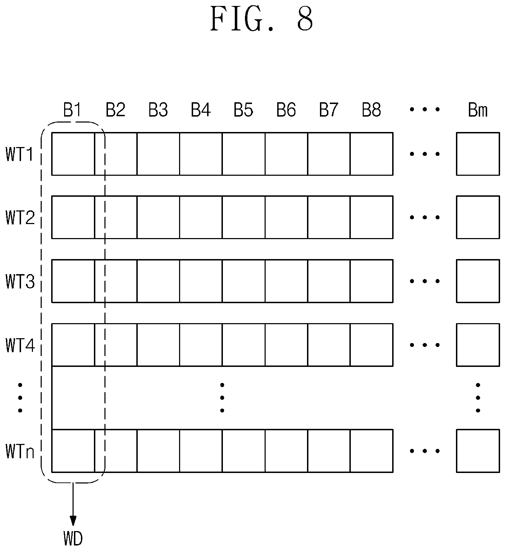

FIG. 8 illustrates the weight data WD according to some example embodiments of the present disclosure. Referring to FIGS. 1 and 8, first to n-th weights WT1 to WTn (n being a positive integer) may be loaded into the accelerator core 140. Each of the first to n-th weights WT1 to WTn may include first to m-th weight bits B1 to Bm (m being a positive integer). In some example embodiments, k-th weight bits (k being a positive integer smaller than or equal to m) of the first to n-th weights WT1 to WTn may constitute one weight data WD.

For example, the variable length polar encoder 130 may output the first weight bits B1 of the first to n-th weights WT1 to WTn. The accelerator core 140 may load the first weight bits B1 of the first to n-th weights WT1 to WTn. As the variable length polar encoder 130 sequentially outputs weight bits of the first to n-th weights WT1 to WTn in units of column, the weight bits of the first to n-th weights WT1 to WTn may be sequentially loaded into the accelerator core 140.

In some example embodiments, in the first to n-th weights WT1 to WTn, valid weights and invalid weights may be distinguished from each other depending on a kind of the machine learning-based inference model (or module) loaded into the accelerator core 140. The valid weights may be weights necessary (or used) to perform the machine learning-based inference. The invalid weights may be weights unnecessary (or not used) to perform the machine learning-based inference.

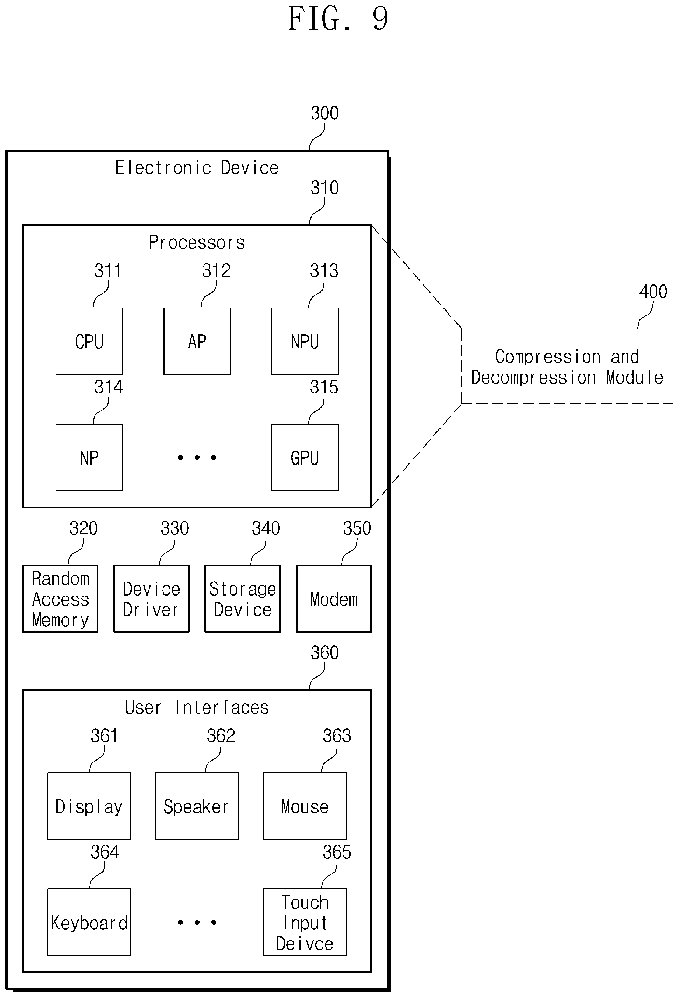

FIG. 9 is a block diagram illustrating an electronic device 300 according to some example embodiments of the present disclosure. Referring to FIG. 9, the electronic device 300 may include processors 310, a random access memory 320, a device driver 330, a storage device 340, a modem 350, and user interfaces 360.

The processors 310 may include, for example, at least one general-purpose processor such as a central processing unit (CPU) 311 or an application processor (AP) 312. Also, the processors 310 may further include at least one special-purpose processor such as a neural processing unit (NPU) 313, a neuromorphic processor (NP) 314, or a graphics processing unit (GPU) 315. The processors 310 may include two or more homogeneous processors.

At least one processor among the processors 310 may include a compression and decompression module 400 as a hardware component or may execute the compression and decompression module 400 as software component. For example, the compression and decompression module 400 may be used to compress weights for machine learning-based inference through polar decoding and to decompress the compressed weights through polar encoding. The compression and decompression module 400 may be used to generate the length-variable compressed weight data CWD_V to be transferred to the accelerator device 100 (refer to FIG. 1).

The random access memory 320 may be used as a working memory of the processors 310 and may be used as a main memory or a system memory of the electronic device 300. The random access memory 320 may include a volatile memory such as a dynamic random access memory or a static random access memory, or a nonvolatile memory such as a phase-change random access memory, a ferroelectric random access memory, a magnetic random access memory, or a resistive random access memory.

The device driver 330 may control the following peripheral devices depending on a request of the processors 310: the storage device 340, the modem 350, and the user interfaces 360. The storage device 340 may include a stationary storage device such as a hard disk drive or a solid state drive, or a removable storage device such as an external hard disk drive, an external solid state drive, or a removable memory card.

The modem 350 may provide remote communication with the external device. The modem 350 may perform wired or wireless communication with the external device. The modem 350 may communicate with the external device based on at least one of various communication schemes such as Ethernet, wireless-fidelity (Wi-Fi), long term evolution (LTE), and 5th generation (5G) mobile communication.

The user interfaces 360 may receive information from the user and may provide information to the user. The user interfaces 360 may include at least one user output interface such as a display 361 or a speaker 362, and at least one user input interface such as a mouse 363, a keyboard 364, or a touch input device 365.

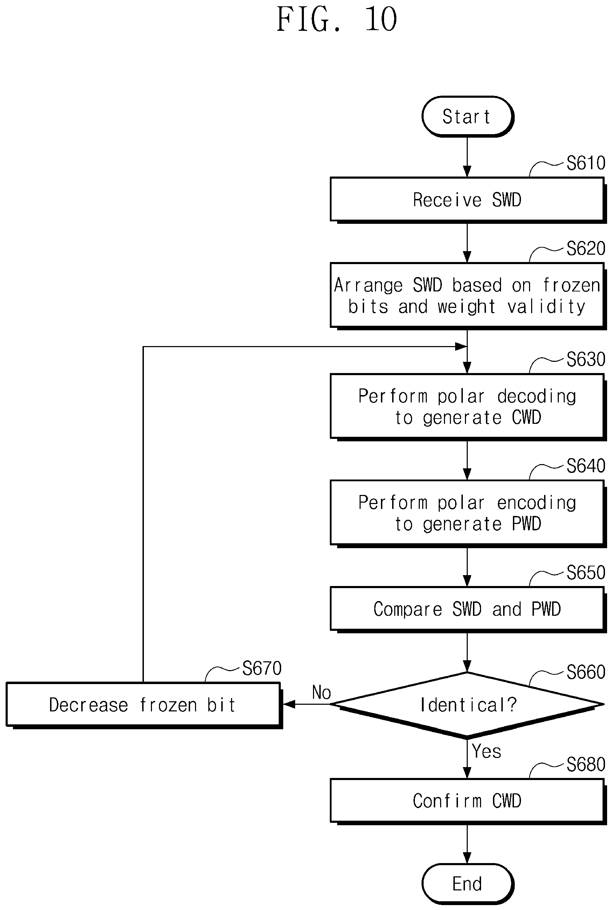

FIG. 10 illustrates a first example of an operating method of the electronic device 300 according to some example embodiments of the present disclosure. For example, a method in which the electronic device 300 controls the accelerator device 100 is illustrated in FIG. 10. Referring to FIGS. 9 and 10, in operation S610, the electronic device 300 may receive source weight data (or original weight data) SWD.

In operation S620, the electronic device 300 may arrange the source weight data SWD based on frozen bits and weight validity. For example, locations of the frozen bits and an error rate of each bit may be determined depending on a structure of an encoding and decoding matrix. The electronic device 300 may arrange the source weight data SWD such that invalid weight bits of the source weight data SWD correspond to the locations of the frozen bits.

In operation S630, the electronic device 300 may perform polar decoding to generate the compressed weight data CWD. For example, the compression and decompression module 400 of the electronic device 300 may generate the compressed weight data CWD by performing polar decoding with respect to the source weight data SWD thus arranged.

In operation S640, the electronic device 300 may perform polar encoding to generate decompressed weight data PWD. For example, the compression and decompression module 400 of the electronic device 300 may generate the decompressed weight data PWD by performing polar encoding with respect to the compressed weight data CWD.

In operation S650, the electronic device 300 may compare the source weight data SWD and the decompressed weight data PWD. For example, the electronic device 300 may compare valid weight bits of the source weight data SWD and valid weight bits of the decompressed weight data PWD.

When it is determined in operation S660 that the source weight data SWD and the decompressed weight data PWD are not identical to each other, the electronic device 300 may perform operation S670. In some example embodiments, when the valid weight bits of the source weight data SWD and the valid weight bits of the decompressed weight data PWD are not identical to each other, an error may have occurred at valid weight bits in the compression (e.g., polar decoding) and decompression (e.g., polar encoding) process.

When an error occurs at valid weight bits in the compression and decompression process, in operation S670, the electronic device 300 may decrease the number of frozen bits. For example, the electronic device 300 may repeatedly perform operation S630 to operation S670 until the valid weight bits of the source weight data SWD and the valid weight bits of the decompressed weight data PWD are identical to each other.

When it is determined in operation S660 that the source weight data SWD and the decompressed weight data PWD are identical to each other, the electronic device 300 may perform operation S680. In operation S680, the electronic device 300 may confirm the compressed weight data CWD. For example, the electronic device 300 may confirm the compressed weight data CWD corresponding to the case where the valid weight bits of the source weight data SWD and the valid weight bits of the decompressed weight data PWD are identical to each other. For example, the electronic device 300 may allow the accelerator device 100 to perform the machine learning-based inference by inputting the compressed weight data CWD to the accelerator device 100.

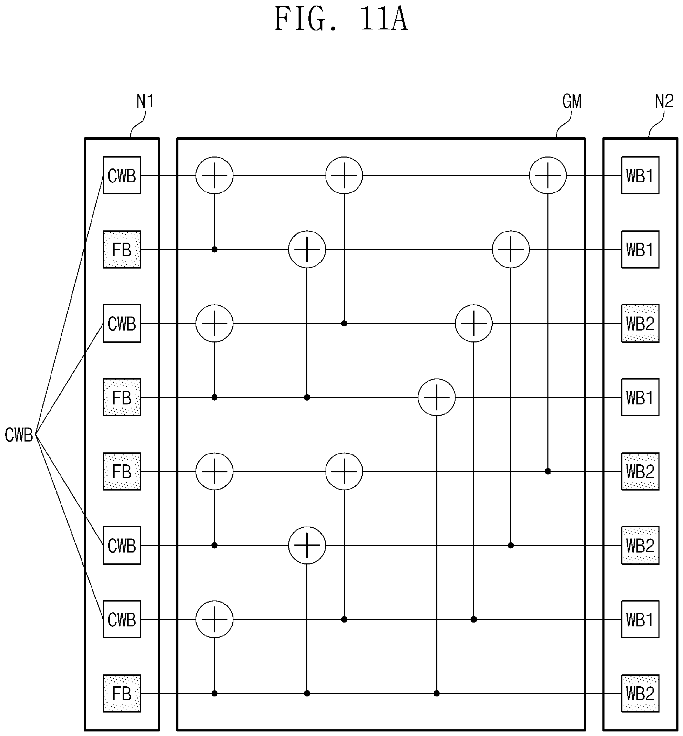

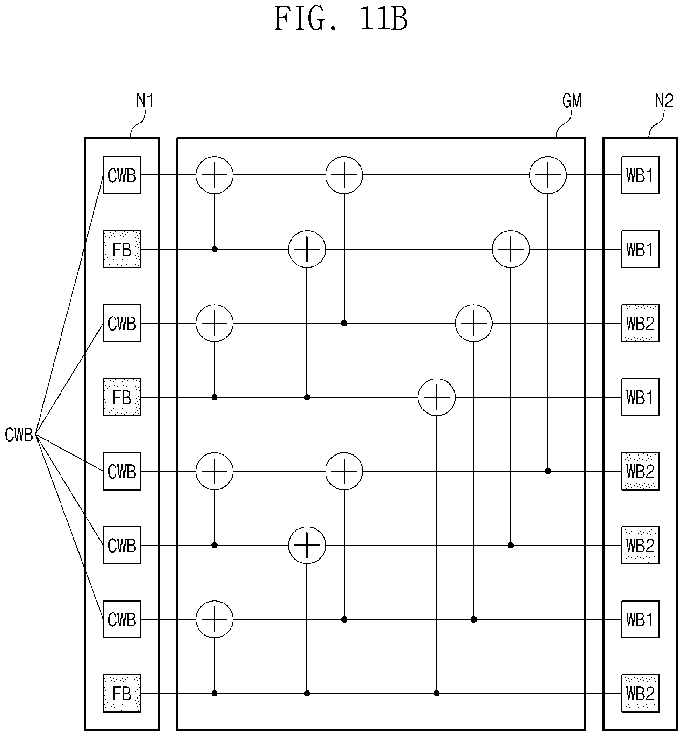

FIGS. 11A and 11B illustrate an example of the process in which the electronic device 300 performs compression and decompression while changing the number of frozen bits. Referring to FIGS. 9, 10, and 11A, compression (e.g., polar decoding) and decompression (e.g., polar encoding) may be performed by using a generator matrix GM. The generator matrix GM may include a plurality of XOR gates connected between paths connecting first nodes N1 and second nodes N2.

The electronic device 300 may determine locations of frozen bits FB of the first nodes N1 based on a structure and a feature of the generator matrix GM. For example, nodes having a relatively high error rate from among the first nodes N1 may be determined as the locations of the frozen bits FB.

The electronic device 300 may determine locations of second weight bits WB2 based on the structure and the feature of the generator matrix GM. For example, nodes having a relatively high error rate from among the second nodes N2 may be determined as the locations of the second weight bits WB2. The second weight bits WB2 may be invalid weight bits.

Alternatively, the electronic device 300 may determine locations of first weight bits WB1 based on the structure and the feature of the generator matrix GM. For example, nodes having a relatively lower error rate from among the second nodes N2 may be determined as the locations of the first weight bits WB1. The first weight bits WB1 may be valid weight bits.

In some example embodiments, the number of frozen bits FB may be 4, the number of first weight bits WB 1 may be 4, and the number of second weight bits WB2 may be 4.

In the compression (e.g., polar decoding) process, the electronic device 300 may load the first weight bits WB1 of the source weight data SWD into some of the second nodes N2 and may load the second weight bits WB2 into the others thereof. The electronic device 300 may designate some of the first nodes N1 as the frozen bits FB and may obtain compressed weight bits CWB from the others thereof. When the number of frozen bits FB is 4, four compressed weight bits CWB may be obtained. The compressed weight bits CWB may constitute the compressed weight data CWD.

In the decompression (e.g., polar encoding) process, the electronic device 300 may designate some of the first nodes N1 as the frozen bits FB and may load the compressed weight bits CWB of the compressed weight data CWD into the others thereof. The electronic device 300 may obtain the first weight bits WB1 of the decompressed weight data PWD from some of the second nodes N2.

When the first weight bits WB1 of the source weight data SWD and the first weight bits WB1 of the decompressed weight data PWD are identical to each other, the electronic device 300 may confirm the compressed weight data CWD. When the first weight bits WB1 of the source weight data SWD and the first weight bits WB1 of the decompressed weight data PWD are not identical to each other, the electronic device 300 may decrease the number of frozen bits FB.

Referring to FIGS. 9, 10, and 11B, the number of frozen bits FB of the first nodes N1 may be decreased to 3. The number of compressed weight bits CWB may be increased to 5. That is, the length of the compressed weight data CWD may be increased to 5.

As described with reference to FIGS. 10, 11A, and 11B, the electronic device 300 may repeat compression and decompression while decreasing the number of frozen bits FB until an error does not occur. Accordingly, the compressed weight data CWD that have a variable length and is free from a defect may be obtained.

A polar encoder has a relatively low complexity compared to other error correction encoders. The accelerator device 100 (refer to FIG. 1) may include the polar encoder and may decompress the compressed weight data CWD being free from a defect by using the polar encoder. Accordingly, power consumption and a time may decrease in the process of decompressing the compressed weight data CWD. Also, because the decompression processes and the process of loading the decompressed weight data WD into the accelerator core 140 are performed in an on-the-fly scheme (or, alternatively, as needed or desired), a time taken to load a plurality of weight data into the accelerator core 140 may be shortened.

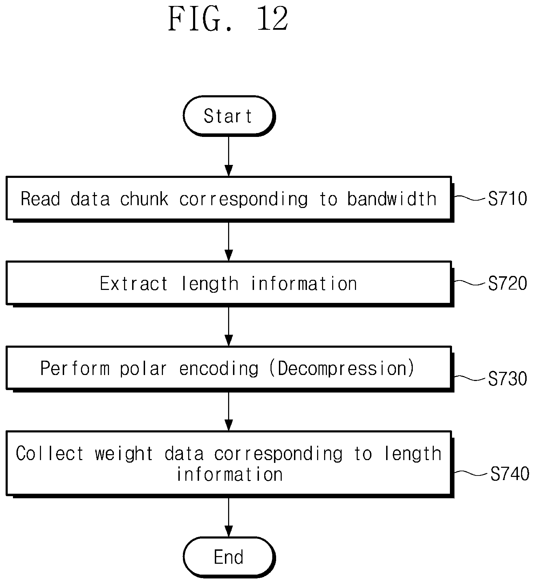

FIG. 12 illustrates a second example of an operating method of the variable length polar encoder 130 according to some example embodiments of the present disclosure. Referring to FIGS. 1 and 12, in operation S710, the variable length polar encoder 130 may read a data chunk corresponding to a bandwidth. For example, the variable length polar encoder 130 may read a data chunk (e.g., the second data chunk described with reference to FIG. 2) corresponding to the communication bandwidth of the memory 120.

In operation S720, the variable length polar encoder 130 may extract length information. For example, the variable length polar encoder 130 may extract the length information at a given location of the read data chunk. The length information may indicate a length of weight data. For example, the given location may mean a given number of leading bits of the data chunk.

When the length information does not exist at the given location of the read data chunk, the variable length polar encoder 130 may omit the extraction of the length information. For example, when length information extracted from a previous data chunk is still valid (e.g., when the whole weight data corresponding to the length information is not collected), the length information may not exist at the given location of the current data chunk or the buffered data.

In operation S730, the variable length polar encoder 130 may perform decompression by performing polar encoding. When the decompression is performed, the variable length polar encoder 130 may discard the length information and may update the length information by extracting next length information.

In operation S740, the variable length polar encoder 130 may collect the weight data WD corresponding to the length information. For example, the weight data WD corresponding to the length information may be collected from one data chunk or may be collected from two or more data chunks.

When the weight data WD corresponding to the length information are collected, the variable length polar encoder 130 may output the weight data WD.

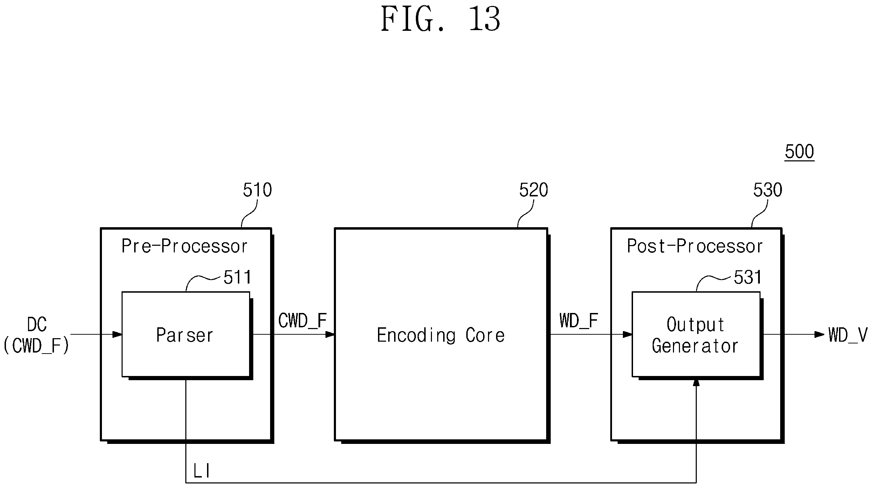

FIG. 13 illustrates a variable length polar encoder 500 according to a second embodiment of the present disclosure. In some example embodiments, the variable length polar encoder 500 may correspond to the variable length polar encoder 130 of FIG. 1.

Referring to FIGS. 1 and 13, the variable length polar encoder 500 may include a pre-processor 510, an encoding core 520, and a post-processor 530.

The pre-processor 510 may sequentially receive the data chunks DC from the memory 120. At least one data chunk DC may include the length-fixed compressed weight data CWD_F. For example, based on the bandwidth of the memory 120, the length-fixed compressed weight data CWD_F may be received through one data chunk DC or may be received through two or more data chunks DC.

The pre-processor 510 may include a parser 511. The parser 511 may extract the length information LI from the data chunk DC. The length information LI may be received together with the length-fixed compressed weight data CWD_F. When one length-fixed compressed weight data CWD_F are received through two data chunks, the first data chunk may include the length information LI, and the second data chunk may not include the length information LI.

The parser 511 may output the extracted length information LI to the post-processor 530. The parser 511 may output the length-fixed compressed weight data CWD_F to the encoding core 520.

The encoding core 520 may receive the length-fixed compressed weight data CWD_F from the pre-processor 510. The encoding core 520 may decompress the length-fixed compressed weight data CWD_F by performing polar encoding with respect to the length-fixed compressed weight data CWD_F. The encoding core 520 may generate the length-fixed weight data WD_F as a decompression result. The encoding core 520 may output the length-fixed weight data WD_F to the post-processor 530.

In some example embodiments, when the length-fixed compressed weight data CWD_F are received through two or more data chunks DC, until the whole length-fixed compressed weight data CWD_F are collected, the length-fixed compressed weight data CWD_F may be buffered in the pre-processor 510 or the encoding core 520.

The post-processor 530 may receive the length-fixed weight data WD_F from the encoding core 520. Some bits of the length-fixed weight data WD_F may be weight bits (e.g., including valid weight bits and invalid weight bits), and the remaining bits thereof may be invalid bits (e.g., dummy bits or padding bits). The length information LI may include information about a length (or the number) of weight bits.

The post-processor 530 may include an output generator 531. The output generator 531 may remove invalid bits from the length-fixed weight data WD_F based on the length information LI. The length of the invalid bits may vary depending on the length-fixed weight data WD_F. By removing the invalid bits, the output generator 531 may collect length-variable weight data WD_V. The output generator 531 may output the length-variable weight data WD_V.

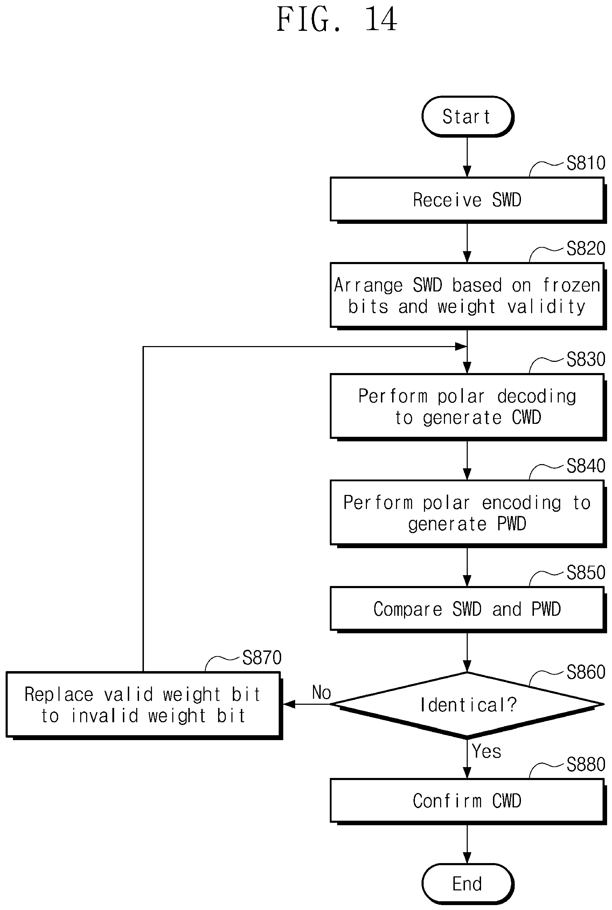

FIG. 14 is a diagram illustrating a second example of an operating method of an electronic device according to some example embodiments of the present disclosure. For example, a method in which the electronic device 300 controls the accelerator device 100 is illustrated in FIG. 14. Referring to FIGS. 9 and 14, in operation S810, the electronic device 300 may receive the source weight data SWD.

In operation S820, the electronic device 300 may arrange the source weight data SWD based on frozen bits and weight validity. For example, locations of the frozen bits and an error rate of each bit may be determined depending on a structure of an encoding and decoding matrix. The electronic device 300 may arrange the source weight data SWD such that invalid weight bits of the source weight data SWD correspond to the locations of the frozen bits.

In operation S830, the electronic device 300 may perform polar decoding to generate the compressed weight data CWD. For example, the compression and decompression module 400 of the electronic device 300 may generate the compressed weight data CWD by performing polar decoding with respect to the source weight data SWD thus arranged.

In operation S840, the electronic device 300 may perform polar encoding to generate the decompressed weight data PWD. For example, the compression and decompression module 400 of the electronic device 300 may generate the decompressed weight data PWD by performing polar encoding with respect to the compressed weight data CWD.

In operation S850, the electronic device 300 may compare the source weight data SWD and the decompressed weight data PWD. For example, the electronic device 300 may compare valid weight bits of the source weight data SWD and valid weight bits of the decompressed weight data PWD.

When it is determined in operation S860 that the source weight data SWD and the decompressed weight data PWD are not identical to each other, the electronic device 300 may perform operation S870. In some example embodiments, when the valid weight bits of the source weight data SWD and the valid weight bits of the decompressed weight data PWD are not identical to each other, an error may have occurred at valid weight bits in the compression (e.g., polar decoding) and decompression (e.g., polar encoding) process.

When an error occurs at valid weight bits in the compression and decompression process, in operation S870, the electronic device 300 may replace the valid weight bits with invalid weight bits. That is, the electronic device 300 may decrease the number of valid weight bits and may increase the number of invalid weight bits. For example, the electronic device 300 may repeatedly perform operation S830 to operation S870 until the valid weight bits of the source weight data SWD and the valid weight bits of the decompressed weight data PWD are identical to each other.

When it is determined in operation S860 that the source weight data SWD and the decompressed weight data PWD are identical to each other, the electronic device 300 may perform operation S880. In operation S880, the electronic device 300 may confirm the compressed weight data CWD. For example, the electronic device 300 may confirm the compressed weight data CWD corresponding to the case where the valid weight bits of the source weight data SWD and the valid weight bits of the decompressed weight data PWD are identical to each other. For example, the electronic device 300 may allow the accelerator device 100 to perform the machine learning-based inference by inputting the compressed weight data CWD to the accelerator device 100.

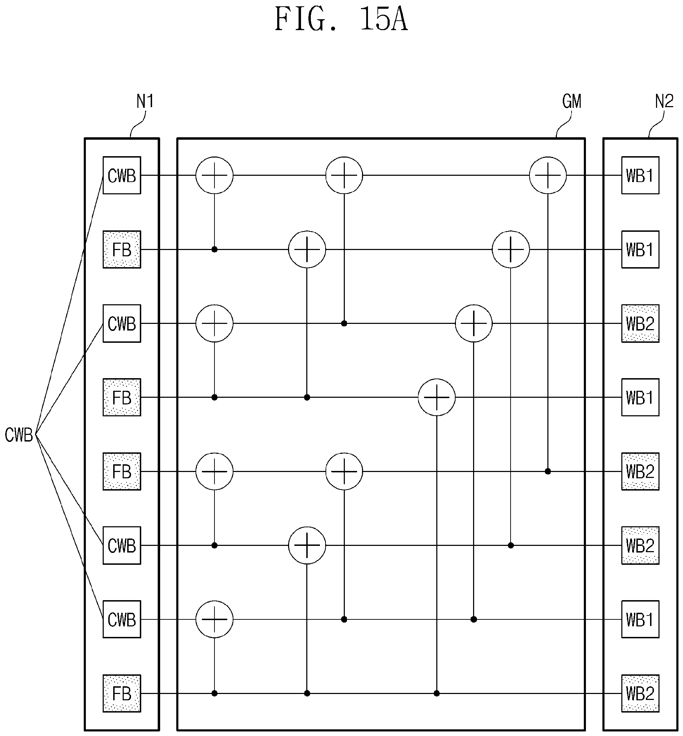

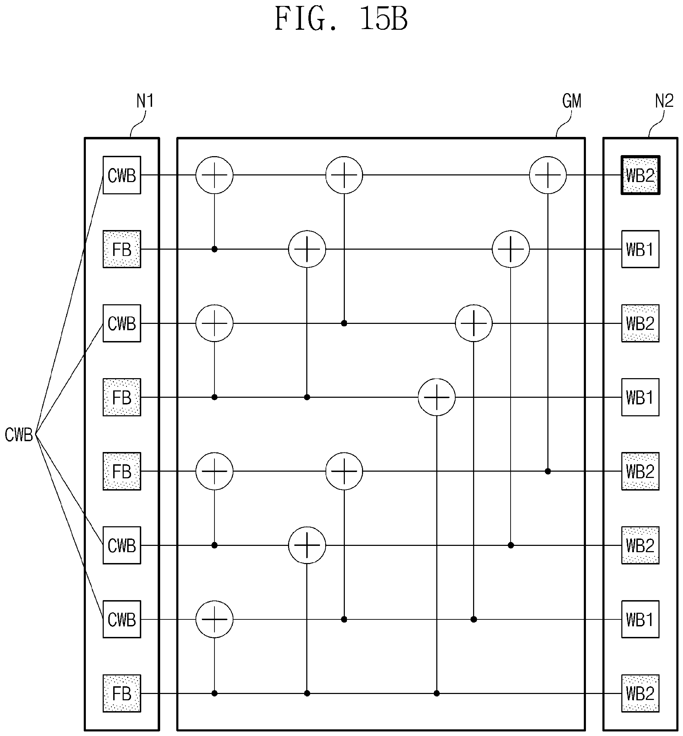

FIGS. 15A and 15B illustrate an example of the process in which the electronic device 300 performs compression and decompression while changing the number of frozen bits. Referring to FIGS. 9, 10, and 15A, compression (e.g., polar decoding) and decompression (e.g., polar encoding) may be performed by using the generator matrix GM. The generator matrix GM may include the plurality of XOR gates ⊕̅ connected between paths connecting the first nodes N1 and the second nodes N2.

The electronic device 300 may determine locations of the frozen bits FB of the first nodes N1 based on a structure and a feature of the generator matrix GM. For example, nodes having a relatively high error rate from among the first nodes N1 may be determined as the locations of the frozen bits FB.

The electronic device 300 may determine locations of second weight bits WB2 based on the structure and the feature of the generator matrix GM. For example, nodes having a relatively high error rate from among the second nodes N2 may be determined as the locations of the second weight bits WB2. The second weight bits WB2 may be invalid weight bits.

Alternatively, the electronic device 300 may determine locations of first weight bits WB1 based on the structure and the feature of the generator matrix GM. For example, nodes having a relatively lower error rate from among the second nodes N2 may be determined as the locations of the first weight bits WB1. The first weight bits WB1 may be valid weight bits.

In some example embodiments, the number of frozen bits FB may be 4, the number of first weight bits WB 1 may be 4, and the number of second weight bits WB2 may be 4.

In the compression (e.g., polar decoding) process, the electronic device 300 may load the first weight bits WB1 of the source weight data SWD into some of the second nodes N2 and may load the second weight bits WB2 into the others thereof. The electronic device 300 may designate some of the first nodes N1 as the frozen bits FB and may obtain the compressed weight bits CWB from the others thereof. When the number of frozen bits FB is 4, four compressed weight bits CWB may be obtained. The compressed weight bits CWB may constitute the compressed weight data CWD.

In the decompression (e.g., polar encoding) process, the electronic device 300 may designate some of the first nodes N1 as the frozen bits FB and may load the compressed weight bits CWB of the compressed weight data CWD into the others thereof. The electronic device 300 may obtain the first weight bits WB1 of the decompressed weight data PWD from some of the second nodes N2.

When the first weight bits WB1 of the source weight data SWD and the first weight bits WB1 of the decompressed weight data PWD are identical to each other, the electronic device 300 may confirm the compressed weight data CWD. When the first weight bits WB1 of the source weight data SWD and the first weight bits WB1 of the decompressed weight data PWD are not identical to each other, the electronic device 300 may decrease the number of first weight bits WB1 and may increase the number of second weight bits WB2.

Referring to FIGS. 9, 10, and 15B, the number of first weight bits WB1 of the second nodes N2 may be decreased to 3. The number of second weight bits WB2 of the second nodes N2 may be increased to 5. The number of compressed weight bits CWB may be maintained at 4. That is, the length of the compressed weight data CWD may be maintained at 4.

As described with reference to FIGS. 10, 15A, and 15B, the electronic device 300 may repeat compression and decompression while decreasing the number of first weight bits WB1 and increasing the number of second weight bits WB2 until an error does not occur. Accordingly, the compressed weight data CWD that have a fixed length and is free from a defect may be obtained.

In some example embodiments, the first weight bit WB1 replaced in the compression process may be compressed together with next source weight data SWD.

A polar encoder has reduced complexity compared to other error correction encoders. The accelerator device 100 (refer to FIG. 1) may include the polar encoder and may decompress the compressed weight data CWD being free from a defect by using the polar encoder. Accordingly, power consumption and a time may decrease in the process of decompressing the compressed weight data CWD. Also, because the decompression processes and the process of loading the decompressed weight data WD into the accelerator core 140 are performed in an on-the-fly scheme (or, alternatively, as needed or desired), a time taken to load a plurality of weight data into the accelerator core 140 may be shortened.

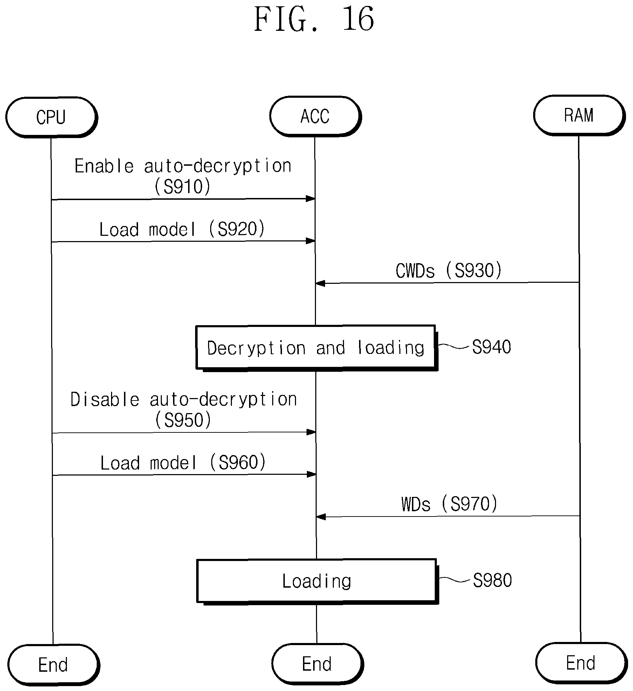

FIG. 16 illustrates another example of an operating method of the electronic device 300 according to some example embodiments of the present disclosure. Referring to FIGS. 1, 9, and 16, in some example embodiments, the electronic device 300 may include the accelerator device 100 as one of the processors 310. For brief description, operations between a central processing unit CPU (or 311) among the processors 310, an accelerator device ACC (or 100), and a random access memory RAM (or 320) will be described.

In operation S910, the central processing unit CPU may request the accelerator device ACC to enable auto-decryption. The accelerator device ACC may enable the auto-decryption in response to the request of the central processing unit CPU.

In operation S920, the central processing unit CPU may request loading a model. For example, the central processing unit CPU may request the loading of first machine learning-based inference.

In response to the request of the central processing unit CPU, in operation S930, the accelerator device ACC may receive a plurality of compressed weight data CWDs from the random access memory RAM. In operation S940, the central processing unit CPU may perform decryption and loading with respect to the plurality of compressed weight data CWDs.

In operation S950, the central processing unit CPU may request the accelerator device ACC to disable the auto-decryption. The accelerator device ACC may disable the auto-decryption in response to the request of the central processing unit CPU.

In operation S960, the central processing unit CPU may request loading a model. For example, the central processing unit CPU may request the loading of second machine learning-based inference.

In response to the request of the central processing unit CPU, in operation S970, the accelerator device ACC may receive a plurality of weight data WDs from the random access memory RAM. In operation S980, the central processing unit CPU may perform loading with respect to the plurality of weight data CWDs.

As described above, the accelerator device ACC may enable or disable the auto-decryption in response to the request of the central processing unit CPU. When the auto-decryption is enabled, the accelerator device ACC may perform loading after performing decompression with respect to data received as weight data. When the auto-decryption is disabled, the accelerator device ACC may perform loading without the decompression of the data received as weight data.

When the size of the weight data WD is relatively small (e.g. has a size below a predefined threshold), the weight data WD may not be compressed, and thus, it may be possible to decrease a power and a time necessary for the accelerator device ACC to perform decompression. When the size of the weight data WD is relatively great (e.g. has a size above a predefined threshold), the weight data WD may be compressed, and thus, it may be possible to decrease a power, a bandwidth, and a time necessary to communicate the weight data WD with the accelerator device ACC.

In the above example embodiments, components according to the present disclosure are described by using the terms "first", "second", "third", etc. However, the terms "first", "second", "third", etc. may be used to distinguish components from each other and do not limit the present disclosure. For example, the terms "first", "second", "third", etc. do not involve an order or a numerical meaning of any form.

In the above example embodiments, components according to embodiments of the present disclosure are referenced by using blocks. The blocks may be implemented with various hardware devices, such as an integrated circuit, an application specific IC (ASIC), a field programmable gate array (FPGA), and a complex programmable logic device (CPLD), firmware driven in hardware devices, software such as an application, or a combination of a hardware device and software. Also, the blocks may include circuits implemented with semiconductor elements in an integrated circuit, or circuits enrolled as an intellectual property (IP).

As described herein, any electronic devices and/or portions thereof according to any of the example embodiments may include, may be included in, and/or may be implemented by one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a DRAM device, storing a program of instructions, and a processor (e.g., CPU) configured to execute the program of instructions to implement the functionality and/or methods performed by some or all of any devices, systems, modules, units, controllers, circuits, architectures, and/or portions thereof according to any of the example embodiments, and/or any portions thereof.

According to example embodiments of the present disclosure, an accelerator device may include a variable length polar encoder, and the variable length polar encoder may decompress compressed weight data without a defect. Because it is possible to decompress the compressed weight data with the reduced complexity, an accelerator device supporting machine learning-based inference while improving an operating speed and reducing power consumption, and a method of controlling the accelerator device are provided.

While the present disclosure has been described with reference to example embodiments thereof, it will be apparent to those of ordinary skill in the art that various changes and modifications may be made thereto without departing from the scope of the present disclosure as set forth in the appended claims.

Embodiments are set out in the following clauses.
1. An accelerator device comprising:
   an interface circuit configured to communicate with an external device;
   a memory configured to
      store first data received through the interface circuit, the first data being compressed weight data and being variable in length;
   a polar encoder configured to
      perform polar encoding with respect to the first data provided from the memory and
      output a result of the polar encoding as second data, the second data being decompressed weight data; and
   an accelerator core configured to
      load the second data, and
      perform machine learning-based inference based on the second data.
2 The accelerator device of clause 1, wherein the polar encoder is configured to access the first data as a first data chunk together with second compressed weight data, based on a bandwidth of the memory.
3 The accelerator device of clause 2, wherein
   the first data chunk includes first length information corresponding to the first data, and
      the polar encoder is configured to
   extract the first length information from the first data chunk; and
   collect the first data from the first data chunk based on the first length information.
4 The accelerator device of clause 3, wherein the polar encoder is configured to add padding data to the first data to generate third data of a fixed length; and perform the polar encoding with respect to the third data to generate the second data.
5 The accelerator device of any of clauses 2 to 4, wherein the polar encoder is configured to
   extract second length information from the second compressed weight data included in the first data chunk and a second data chunk following the first data chunk.
6 The accelerator device of any preceding clause, wherein the polar encoder is configured to access the first data divided into at least two data chunks based on a bandwidth of the memory.
7 The accelerator device of clause 6, wherein the polar encoder is configured to
   extract first length information from a first data chunk among the at least two data chunks; and
   receive data chunks until data corresponding to the first length information are collected.
8. An accelerator device comprising:
   an interface circuit configured to communicate with an external device;
   a memory configured to store first data received through the interface circuit, the first data being compressed weight data;
   a polar encoder configured to
      perform polar encoding with respect to the first data provided from the memory, and
      output a result of the polar encoding as second data, the second data being decompressed weight data and variable in length; and
   an accelerator core configured to
      load the second data, and
      perform machine learning-based inference based on the second data.
9 The accelerator device of clause 8, wherein the polar encoder is configured to access first data included in a first data chunk based on a bandwidth of the memory.
10 The accelerator device of clause 9, wherein the first data chunk further includes first length information corresponding to the first data, and
   wherein the polar encoder is configured to
   extract the first length information from the first data chunk;
   perform the polar encoding with respect to the first data to generate third data; and
   extract the second data from the third data based on the first length information.
11 The accelerator device of any of clauses 8 to 10, wherein the polar encoder is configured to access the first data divided into at least two data chunks based on a bandwidth of the memory.
12 The accelerator device of clause 11, wherein
   a first data chunk among the at least two data chunks includes first length information corresponding to the first data, and
   the polar encoder is configured to repeat operations of
   extracting the first length information from the first data chunk;
   receiving data chunks until data corresponding to the first length information are collected; and
   performing the polar encoding with respect to each of the data chunks.
13. A method of controlling an accelerator device which includes a polar encoder and an accelerator core, the method comprising:
   inputting first data to the polar encoder, the first data being compressed weight data;
   performing, at the polar encoder, polar encoding with respect to the first data to generate second data, the second data are decompressed weight data;
   loading the second data into the accelerator core; and
   performing, at the accelerator core, machine learning-based inference based on the second data,
   one of the first data and the second data being variable in length.
14 The method of clause 13, further comprising:
   generating the first data,
   wherein the generating of the first data includes:
      performing polar decoding with respect to source weight data to generate third data;
      performing the polar encoding with respect to the third data to generate fourth data;
      comparing the source weight data and the fourth data; and
      based on partial data of the source weight data matching with partial data of the fourth data, which correspond to the partial data of the source weight data, confirming remaining bits other than frozen bits of the third data as the first data.
15 The method of clause 14, wherein the generating of the first data further includes:
   based on the partial data of the source weight data not matching with the partial data of the fourth data, decreasing a number of frozen bits of the third data.
16 The method of clause 15, wherein the generating of the first data further includes:
   until the partial data of the source weight data are matched with the partial data of the fourth data, performing the generating of the third data, the generating of the fourth data, and the comparing while sequentially decreasing the number of frozen bits.
17 The method of any of clauses 14 to 16, wherein the generating of the first data further includes:
   based on the partial data of the source weight data not matching with the partial data of the fourth data, decreasing a size of the partial data of the source weight data.
18 The method of clause 17, wherein the generating of the first data further includes:
   until the partial data of the source weight data are matched with the partial data of the fourth data, performing the generating of the third data, the generating of the fourth data, and the comparing while sequentially decreasing the size of the source weight data.
19 The method of any of clauses 14 to 18, wherein the partial data of the source weight data include weight data necessary for the accelerator core to perform the machine learning-based inference.
20 The method of clause 19, wherein a location of the partial data of the source weight data is changed depending on a kind of a machine learning-based module corresponding to the source weight data.

## Claims

1. An accelerator device comprising:
an interface circuit configured to communicate with an external device;
a memory configured to
store first data received through the interface circuit, the first data being compressed weight data and being variable in length;
a polar encoder configured to
perform polar encoding with respect to the first data provided from the memory and
output a result of the polar encoding as second data, the second data being decompressed weight data; and
an accelerator core configured to
load the second data, and
perform machine learning-based inference based on the second data.

2. The accelerator device of claim 1, wherein the polar encoder is configured to access the first data as a first data chunk together with second compressed weight data, based on a bandwidth of the memory.

3. The accelerator device of claim 2, wherein
the first data chunk includes first length information corresponding to the first data, and
the polar encoder is configured to
extract the first length information from the first data chunk; and
collect the first data from the first data chunk based on the first length information.

4. The accelerator device of claim 3, wherein the polar encoder is configured to
add padding data to the first data to generate third data of a fixed length; and
perform the polar encoding with respect to the third data to generate the second data.

5. The accelerator device of any of claims 2 to 4, wherein the polar encoder is configured to
extract second length information from the second compressed weight data included in the first data chunk and a second data chunk following the first data chunk.

6. The accelerator device of any preceding claim, wherein the polar encoder is configured to access the first data divided into at least two data chunks based on a bandwidth of the memory.

7. The accelerator device of claim 6, wherein the polar encoder is configured to
extract first length information from a first data chunk among the at least two data chunks; and
receive data chunks until data corresponding to the first length information are collected.

8. An accelerator device comprising:
an interface circuit configured to communicate with an external device;
a memory configured to store first data received through the interface circuit, the first data being compressed weight data;
a polar encoder configured to
perform polar encoding with respect to the first data provided from the memory, and
output a result of the polar encoding as second data, the second data being decompressed weight data and variable in length; and
an accelerator core configured to
load the second data, and
perform machine learning-based inference based on the second data.

9. The accelerator device of claim 8, wherein the polar encoder is configured to access first data included in a first data chunk based on a bandwidth of the memory.

10. The accelerator device of claim 9, wherein the first data chunk further includes first length information corresponding to the first data, and
wherein the polar encoder is configured to
extract the first length information from the first data chunk;
perform the polar encoding with respect to the first data to generate third data; and
extract the second data from the third data based on the first length information.

11. The accelerator device of any of claims 8 to 10, wherein the polar encoder is configured to access the first data divided into at least two data chunks based on a bandwidth of the memory.

12. The accelerator device of claim 11, wherein
a first data chunk among the at least two data chunks includes first length information corresponding to the first data, and
the polar encoder is configured to repeat operations of
extracting the first length information from the first data chunk;
receiving data chunks until data corresponding to the first length information are collected; and
performing the polar encoding with respect to each of the data chunks.

13. A method of controlling an accelerator device which includes a polar encoder and an accelerator core, the method comprising:
inputting first data to the polar encoder, the first data being compressed weight data;
performing, at the polar encoder, polar encoding with respect to the first data to generate second data, the second data are decompressed weight data;
loading the second data into the accelerator core; and
performing, at the accelerator core, machine learning-based inference based on the second data,
one of the first data and the second data being variable in length.

14. The method of claim 13, further comprising:
generating the first data,
wherein the generating of the first data includes:
performing polar decoding with respect to source weight data to generate third data;
performing the polar encoding with respect to the third data to generate fourth data;
comparing the source weight data and the fourth data; and
based on partial data of the source weight data matching with partial data of the fourth data, which correspond to the partial data of the source weight data, confirming remaining bits other than frozen bits of the third data as the first data.

15. The method of claim 14, wherein the generating of the first data further includes:
based on the partial data of the source weight data not matching with the partial data of the fourth data, decreasing a number of frozen bits of the third data.
